# EUROPEAN PATENT APPLICATION

(11) **EP 1 909 127 A2**
(43) Date of publication of application: **09.04.2008**
(21) Application number: 07117837.0
(22) Date of filing: 03.10.2007
(51) Int. Cl.: G02B 6/42

(54) **Lens and Tube Body Constituting an Element of an Optical Communication Module**

(30) Priority: 04.10.2006 JP 2006272534
(71) Applicant: YAZAKI CORPORATION, Minato-ku, Tokyo (JP)
(72) Inventor: MIYANARI, Motonori, Susono-shi Shizuoka (JP); SERIZAWA, Naoshi, Susono-shi Shizuoka (JP); MATSUKURA, Hisao, Ageo-shi Saitama (JP)
(74) Representative: Brunner, Michael John

(57) **Abstract**

An optical communication lens arranged between an optical element and an optical fiber terminal includes a first lens part having an aspherical convex shape facing the optical element, a second lens part having an aspherical convex shape facing the optical fiber terminal, and an intermediate part integrally formed with the first lens part and the second lens part therebetween. The first lens part, the second lens part and the intermediate part are integrally formed and are comprised of a resin having optical transparency. Shapes of the first lens part and the second lens part are asymmetric to each other. The second lens part is thicker than the first lens part.

## Description

The present invention relates to an optical communication lens interposed between a light emitting element or a light receiving element and an optical fiber terminal and a tube body of an optical element module using the optical communication lens.

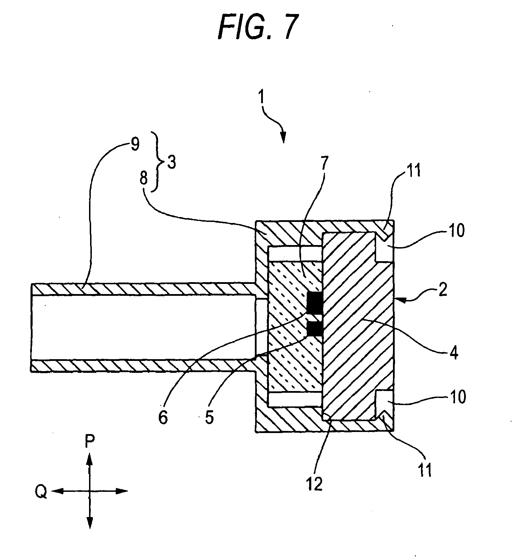

As a related art optical element module, one disclosed for example in JP-A-2006-30813 is known. In Fig. 7, an optical element module 1 includes a light emitting device 2 and an enclosure 3. The optical element module 1 shown in Fig. 7 serves as a light emitting side in optical communications. The light emitting device 2 includes a substrate 4, a light emitting element 5 and an electronic component 6 mounted on the front surface of the substrate 4, and a sealing resin 7 for sealing the light emitting element 5 and the electronic component 6. The enclosure 3 includes a main body 8 and a tube body 9 for inserting optical fibers to be integrated with the main body 8 and is formed into an illustrated shape.

At the rear part of the substrate 4 of the light emitting device 2 are formed a plurality of latching concave parts 10. In the concave parts 10 are engaged latching hook parts 11 formed on the main body 8 of the enclosure 3. The light emitting device 2 is housed in contact with a stepped part 12 inside the main body 8. The light emitting device 2 is prevented from dropping by way of the fitting engagement of the concave parts 10 and the hook parts 11.

In this arrangement, when the light emitting device 2 is fitted into the main body 8, the light emitting element 5 is exposed through the sealing resin 7 from the opening at the tip of the tube body 9 of the enclosure 3. When an optical fiber terminal is inserted into the tube body 9, the inserted optical fiber terminal is opposed to the light emitting element 5. While not illustrated, the optical fiber terminal has a ferrule mounted thereon having an outer diameter matching the inner diameter of the tube body 9.

In the related art, the ferrule mounted on the optical fiber terminal is inserted into the tube body 9 so that the inner diameter of the tube body 9 has a dimension slightly larger than the outer diameter of the ferrule. Thus, the ferrule may be axially misaligned in the direction of an arrow P shown in Fig. 7 by a difference in dimension from the tube body 9. This presents a problem that an optical signal from the light emitting element 5 is not adequately coupled to the optical fiber exposed from the end surface of the ferrule. In other words, the related art includes an element that degrades the coupling efficiency. Further, an optical signal from the light emitting element 5 cannot be adequately connected in case the ferrule is inserted to a shallow depth into the tube body 9, that is, to a shallow depth in the direction of the arrow Q shown in Fig. 7.

In recent years, the increasing amount of information transfer volume and growing needs for real-time processing require a higher transmission speed of an optical signal. Reducing the light receiving area of an optical fiber is needed to attain a higher transmission speed. The problem is that a reduced light receiving area of an optical fiber may not be supported by the optical element module 1 with lower coupling efficiency.

The invention has been accomplished in view of the above circumstances. An object of the invention is to provide an optical communication lens capable of enhancing the optical coupling efficiency and a tube body of an optical element module using the optical communication lens.

In order to solve the problem, the invention provides An optical communication lens arranged between an optical element and an optical fiber terminal, comprising:
a first lens part having an aspherical convex shape facing the optical element;
a second lens part having an aspherical convex shape facing the optical fiber terminal; and
an intermediate part integrally formed with the first lens part and the second lens part therebetween,
wherein the first lens part, the second lens part and the intermediate part are integrally formed and are comprised of a resin having optical transparency;
wherein shapes of the first lens part and the second lens part are asymmetric to each other; and
wherein the second lens part is thicker than the first lens part.

Preferably, the optical element is a light emitting element, and the first lens part is formed into a shape that when a light from the light emitting element passes through from the first lens part to the second lens part, the light propagating through the intermediate part is extended in a direction of propagation.

Preferably, the optical element is a light receiving element, and the second lens part is formed into a shape that when a light from the optical fiber terminal passes through from the second lens part to the first lens part, the light propagating through the intermediate part is narrowed in a direction of propagation.

With the invention having such a characteristic, it is possible to arrange a lens having a desired aberration between a light emitting element or a light receiving element (an optical element) and an optical fiber terminal. An optical communication lens of the invention is formed into the shape according to the invention and has an aberration so that it ensures high coupling efficiency even in the presence of slight misalignment of the light emitting element or light receiving element and the optical fiber terminal. Introduction of an aberration provides a focus as a circle having an area rather than a single point at a focal point. The invention thus ensures high coupling efficiency. With the optical communication lens of the invention, providing an aberration in the shape according to the invention obtains a spot diameter ample enough in terms of coupling even when the optical fiber terminal is brought near or placed away from the inventive optical communication lens. High coupling efficiency is provided in this case also.

Preferably, the optical element is Vertical Cavity Surface Emitting Laser (VCSEL) or Photo Diode (PD), and the optical fiber is Polymer Clad Fiber (PCF).

With the invention having such a characteristic, as understood from the first aspect of the invention, an optical communication lens having high coupling efficiency is provided. The optical communication lens includes a light emitting element or a light receiving element using a VCSEL (laser diode) or a PD (photo diode) and an optical fiber using a PCF (Polymer Clad Fiber). This ensures a higher transmission speed.

In order to solve the problem, the invention provides a tube body for a optical device module having an optical element, comprising:
a cylindrical tube part for containing an optical fiber terminal or a ferrule mounted on the optical fiber terminal; and
an optical communication lens to be arranged between the optical element and the optical fiber terminal,
wherein the optical communication lens includes:
a first lens part having an aspherical convex shape facing the optical element;
a second lens part having an aspherical convex shape facing the optical fiber terminal; and
an intermediate part integrally formed with the first lens part and the second lens part therebetween,
wherein the optical communication lens is comprised of a resin having optical transparency;
wherein shapes of the first lens part and the second lens part are asymmetric to each other;
wherein the second lens part is thicker than the first lens part; and
wherein the optical communication lens is integrally formed with the cylindrical tube part therein.

With the invention having such a characteristic, it is possible to provide an optical element module with high coupling efficiency. The configuration of the optical element module will be described under Best Mode for Carrying Out the Invention.

The invention offers an advantage that optical coupling efficiency is enhanced. The invention offers an advantage that the transmission speed is increased. The invention offers an advantage that an optical element module with high coupling efficiency is provided.

The above objects and advantages of the present invention will become more apparent by describing in detail preferred exemplary embodiments thereof with reference to accompanying drawings, wherein like reference numerals designate like or corresponding parts throughout the several views, and wherein:

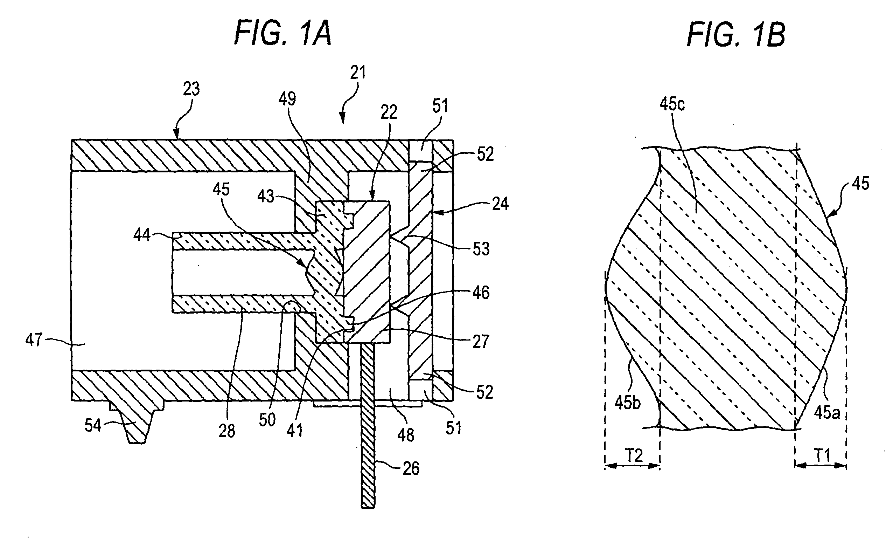

Fig. 1a is a cross-sectional view of an embodiment of an optical element module according to the invention;
Fig. 1 b is a cross-sectional view of an optical communication lens according to the invention;
Fig. 2 is a perspective view of the optical element module;
Fig. 3 is an exploded perspective view of the optical element module;
Fig. 4 is a front view of the optical element module in the sub-assembly state;
Fig. 5 is a cross-sectional view of the optical element module in the sub-assembly state;
Fig. 6 is an explanation drawing related to the coupling efficiency by the optical communication lens; and
Fig. 7 is a cross-sectional view of a related art optical element module.

Referring to Fig. 1, an optical connector 21 used for optical communications includes an optical element module 22, an optical connector housing 23 made of a synthetic resin, and a housing cap 24 made of a synthetic resin. The optical element module 22 includes an optical communication lens 45 according to the invention.

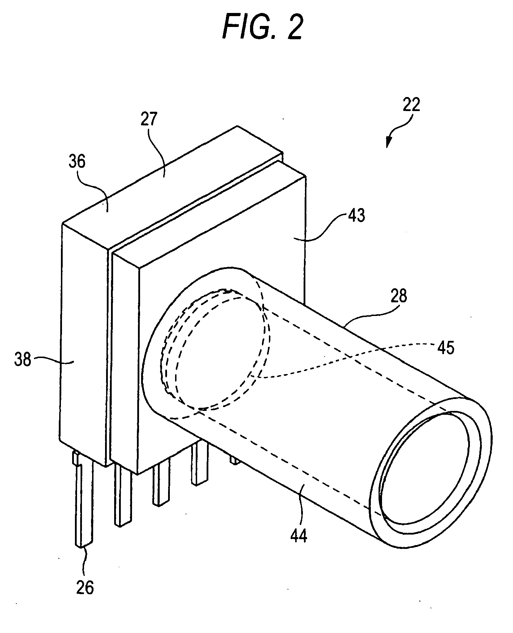

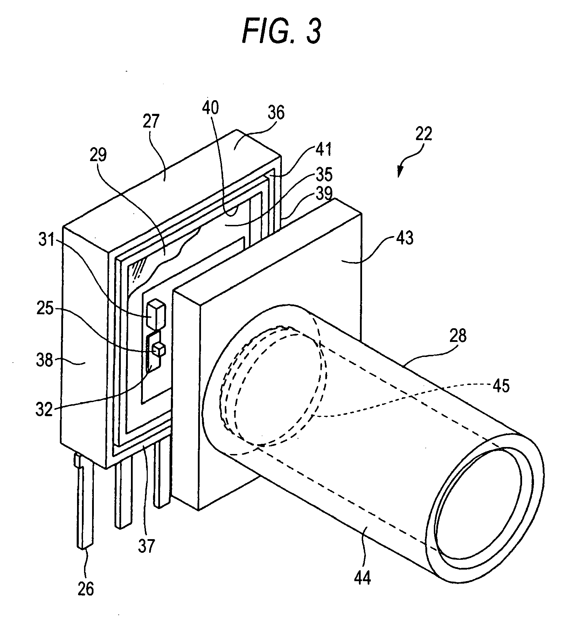

The optical connector 21 in this embodiment is one mounted on a vehicle although the invention is not limited thereto. The optical connector 21 in this embodiment uses two optical element modules 22 according to the invention arranged side by side in the optical connector housing 23 for bidirectional optical communications although the invention is not limited thereto. Another optical element module is arranged at the back of the optical element modules 22 shown in Fig. 1. A configuration dedicated to transmission or reception may be made. The component members of the optical connector 21 will be described referring to Figs. 1 through 5.

The optical element module 22 includes a light emitting element 25 (or light receiving element) (an optical element), a lead frame 26, a resin enclosure 27, a resin tube body 28, a silicone resin sealing part 29, an IC 30 and an electronic component 31.

The light emitting element 25 is mounted on the lead frame 26 together with the lC 30 and the electronic component 31. An optical signal output from the light emitting element 25 is generated by converting an electric signal. As the light emitting element 25, an LED or a VCSEL is generally known. In this example, a VCSEL is used to enhance the transmission speed. The light emitting element 25 is mounted on a small substrate 32 arranged on the lead frame 26.

The lead frame 26 is formed into an illustrated shape by blanking a conductive thin metallic plate. The lead frame 26 is not separated from a carrier formed via blanking until insert forming described later takes place or the light emitting element 25 is mounted.

The lead frame 26 has a through hole 33 formed on the center axis, for example, The through hole 33 is formed to penetrate the lead frame 26 in a diameter slightly larger than the diameter of an ejector pin described later. In close proximity to the through hole 33 is set an element mounting part 34 for the light emitting element 25. The element mounting part 34 is set in the size of the substrate 32. In close proximity to the element mounting part 34 are mounted the IC 30 and the electronic component 31.

An enclosure 27 is formed through resin molding where the lead frame 26 is inserted into a predetermined position. The enclosure 27 is formed into a rectangular shape having an opening at the front and including a shallow bottom. To be more precise, the enclosure 27 is formed to include a rear bottom wall 35, an upper wall 36, a lower wall 37, a left wall 38, a right wall 39 and an opening 40. The opening 40 is formed as a part opened by the ends of the upper wall 36, the lower wall 37, the left wall 38 and the right wall 39. The ends of the upper wall 36, the lower wall 37, the left wall 38 and the right wall 39 are formed to be continuous in a flat plane. In such a flat plane is formed a concave part 41.

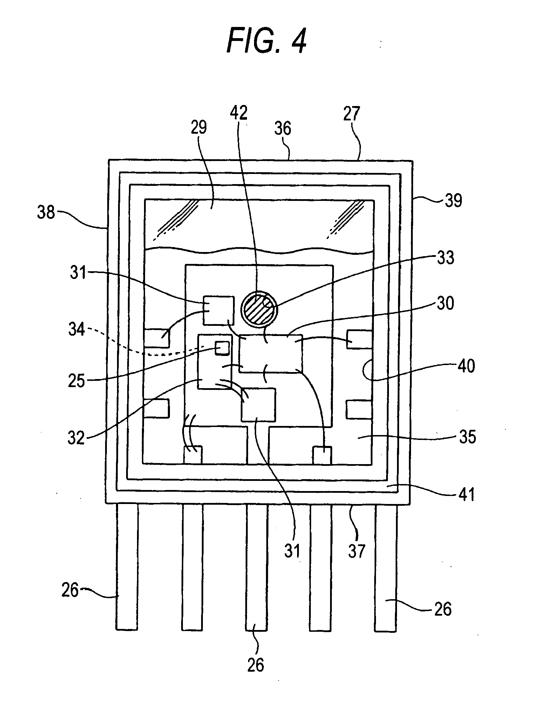

The concave part 41 is formed into a groove-shaped part that has a rectangular shape when the enclosure 27 is viewed from the front as shown in Fig. 4. The concave part 41 is formed outside the opening 40. The concave part 41 is formed as a non-locking uneven part on the enclosure 27. The cross-sectional shape of the concave part 41 is not limited to a rectangle or a square but may be a character of V or U. The shape of the concave part 41 is not particularly limited as long as the tube body 28 can be slightly moved for alignment with a non-locking uneven part (described later) on the tube body 28 inserted. To the concave part 41 is applied a fixing adhesive in the assembly process of the optical element module 22.

The enclosure 27 includes a marker 42 serving as a reference for positioning and used for viewing or image processing. The marker 42 is formed on the rear bottom wall 35 when the lead frame 26 is insert-molded into a predetermined position. To be more precise, the marker 42 is formed when the enclosure 27 is resin-molded. That is, the marker 42 is formed using the marks of the ejector pin of the forming mold. The marker 42 is formed in a position exposed from the through hole 33 of the lead frame 26. The marker 42 is formed by penetrating the ejector pin of the forming mold into the through hole 33 of the lead frame 26 in resin molding of the enclosure 27.

The tube body 28 is formed through resin molding that uses a resin material having optical transparency. The tube body 28 includes a lid part 43, a tube part 44 and an optical communication lens 45 of the invention. The lid part 43, the tube part 44 and the optical communication lens 45 are formed integrally. The tube body 28 is formed of a single component including the lid part 43, the tube part 44 and the optical communication lens 45.

The lid part 43 is formed into a rectangular shape that can cover the opening 40 of the enclosure 27. On the lid part 43 is formed a convex part 46 for fixing via an adhesive at a position on a flat surface of each end of the upper wall 36, lower wall 37, left wall 38 and the right wall 39 of the enclosure 27. The convex part 46 is formed as a non-locking uneven part on the lid part 43. The convex part 46 is formed to the shape and arrangement of the concave part 41 of the enclosure 27.

The convex part 46 may be formed on the enclosure 27 and the concave part 41 may be formed on the lid part 43. The convex part 46 and the concave part 41 are formed in shapes to allow insertion and so that both parts are not engaged to each other. The convex part 46 and the concave part 41 are not designed to fix the tube body 28 and the enclosure 27. Fixing is basically made using an adhesive or equivalent means. The convex part 46 and the concave part 41 have dimensions so that a minute backlash (gap), that is, a backlash necessary for positioning described later will be provided when the convex part 46 is inserted into the concave part 41.

The tube part 44 is formed as a part into which the terminal of an optical fiber is inserted via a ferrule, or the terminal of an optical fiber is inserted directly. The tube part 44 is formed into a cylindrical shape, Inside the tube part 44 is integrated an optical communication lens 45 (or an optical communication lens 45 may be separately formed). The optical communication lens 45 is arranged in close proximity to the continuous part between the tube part 44 and the lid part 43 in this embodiment.

The optical communication lens 45 is arranged to be interposed between the terminal of an optical fiber and a light emitting element 25. The optical communication lens 45 is arranged considering the distance to the optical fiber terminal and the distance to the light emitting element 25. The optical communication lens 45 is formed to be convex on the surface facing the optical fiber terminal and on the surface facing the light emitting element 25. The optical communication lens 45 is formed so that both convex surfaces are aspherical.

As an optical fiber, a POF or a PCF is generally known. In this example, a PCF is used to enhance the transmission speed.

The optical communication lens 45 will be further detailed. The optical communication lens 45 is formed to include: a first aspherical convex lens part 45a (a first lens part) formed into an aspherical shape and convex on the surface facing the light emitting element 25, a second aspherical convex lens part 45b (a second lens part) formed into an aspherical shape and convex on the surface facing the optical fiber terminal, and an intermediate part 45c arranged between the first aspherical convex lens part 45a and the second aspherical convex lens part 45b and continuous thereto. The optical communication lens 45 are formed so that the first aspherical convex lens part 45a and the second aspherical convex lens part 45b are formed into asymmetric shapes.

Talking of the asymmetric shapes, assuming that the lens diameter is the same, thickness T2 of the second aspherical convex lens part 45b is greater than thickness T1 of the first aspherical convex lens part 45a (see Fig. 1b). The asymmetric shapes are formed so that light propagated through the intermediate part 45c will be extended (or narrowed in the case of a light receiving element) in the direction of propagation.

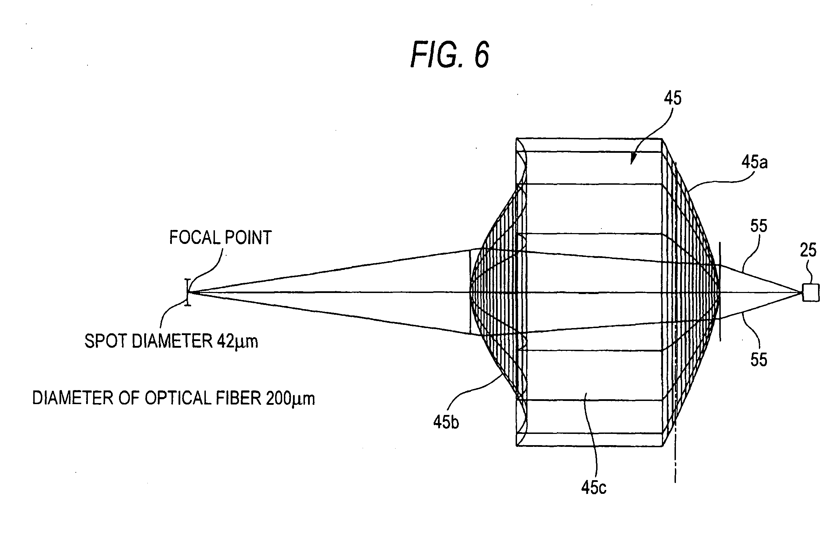

The optical communication lens 45 formed into the above shape generates a desired aberration between the light emitting element 25 and the optical fiber terminal. The optical communication lens 45 in the above shape and providing an aberration assures high coupling efficiency despite slight misalignment of the light emitting element 25 and the optical fiber terminal. That is, introduction of an aberration into the optical communication lens 45 provides a focus as a circle having an area rather than a single point at a focal point. This ensures high coupling efficiency (described later referring to Fig. 6).

The optical communication lens A.5 formed into the above shape obtains a sufficient spot diameter with respect to the coupling even when the optical fiber terminal is brought near or placed away from the optical communication lens 45. This ensures high coupling efficiency in this case also (described later referring to Fig. 6).

A silicone resin sealing part 29 is formed into an illustrated state by potting a silicone resin for sealing into the enclosure 27. The light emitting element 25, the IC 30 and the electronic component 31 mounted on the lead frame 26 are protected by the silicone resin sealing part 29. In this embodiment, the silicone resin sealing part 29 is formed so that its apex surface will be slightly lower than the opening 40.

In a space formed between the apex surface of the silicone resin sealing part 29 and the opening 40 with the tube body 28 mounted on the enclosure 27 exists air, which exits outside via a minute backlash between the convex part 46 and the concave part 41. In this embodiment, a non-fixed part is formed where an adhesive is not applied, where air moves toward the inside and outside.

Next, assembly of the optical element module 22 will be described based on the above configuration.

The lead frame 26 with a carrier attached (otherwise the lead frame 26 could break up) is set into a forming mold. Starting resin molding of the enclosure 27 in this state forms the enclosure 27 with part of the lead frame 26 insert-molded. On the enclosure 27 is formed a positioning marker 42 using the marks of an ejector pin of the forming mold (refer to Fig. 4). The ejector pin is arranged on the mold body with the dimensional precision of the forming mold. Thus, with such an ejector pin, the marker 42 is arranged with high precision.

In formation of the marker 42, the ejector pin penetrates the through hole 33 of the lead frame 26. When the enclosure 27 is resin-molded while the lead frame 26 is being inserted, the lead frame 26 is prevented from being moved by the flow of resin. This completes molding of the enclosure 27 and positioning of the lead frame 26 with high precision.

When the opening 40 is exposed after the enclosure 27 is resin-molded, part of the lead frame 26 is exposed. On the exposed part, the light emitting element 25, the IC 30 and the electronic component 31 are mounted and wiring is made. The light emitting element 25 and the like are mounted using the marker 42 as a positioning reference. Use of the marker 42 allows the light emitting element 25 to be arranged with high precision with respect to the lead frame 26 and the enclosure 27.

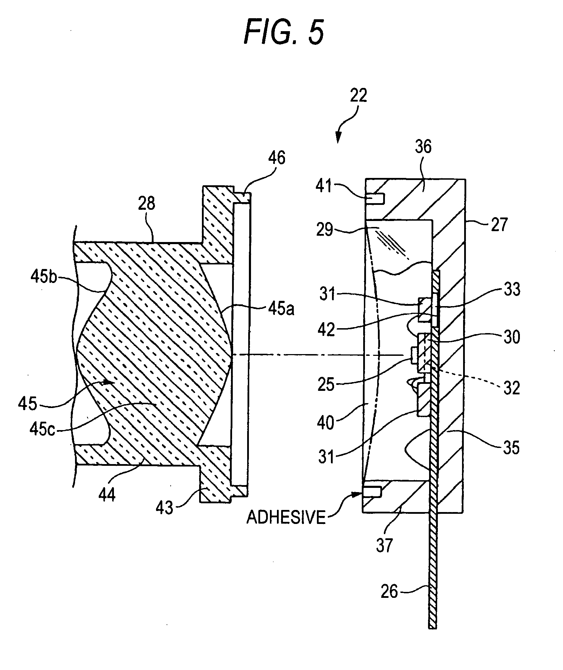

Next, potting of a silicone resin for sealing is made to the enclosure 27. This process forms a silicone resin sealing part 29 in the enclosure 27. The light emitting element 25, the lC 30 and the electronic component 31 mounted on the lead frame 26 are protected by the silicone resin sealing part 29. When the light emitting element 25, the IC 30 and the electronic component 31 mounted on the lead frame 26 are protected by the silicone resin sealing part 29 and the lead frame 26 is detached from the carrier, a sub-assembly as a state before the tube body 28 is fixed is formed as shown in Figs. 4 and 5.

Next, the tube body 28 is fixed to the enclosure 27 by using an adhesive. This work includes a temporary fixing step of applying an adhesive to the concave part 41 of the enclosure 27 and inserting the convex part 46 of the tube body 28 therein, and determining the fixing position of the tube body 28 while using the light emitting element 25 as a positioning reference, and a final fixing step of letting the adhesive harden that is applied to the concave part 41 and completely fixing the tube body 28 to the enclosure 27.

In this embodiment, the adhesive used is for example a thermo-setting epoxy adhesive. The adhesive is applied to the concave part 41 for example on the upper wall 36 and the lower wall 37 of the enclosure 27, and completely secures the tube body 28 onto the enclosure 27 when it hardens with heat treatment (for example, for one hour at 100°C) after the temporary fixing step,

In the temporary fixing step, when the tube body 28 is minutely moved to determine the fixing position by using the light emitting element 25 as a reference, each of the left wall 38 and the right wall 39 of the enclosure 27 and the lid part 43 of the tube body 28 are partially fixed to each other with an instant adhesive (a cyanoacrylate instant adhesive having a UV bonding feature). Partial fixing may be made through laser-based welding. This maintains the enclosure 27 and the tube body 28 in stable position without dislocating from each other while a thermo-setting epoxy adhesive is hardening. Once the thermo-setting epoxy adhesive hardens, the tube body 28 is fixed to the enclosure 27 with the center axis of the tube part 44 aligned with the light emitting element 25.

When the thermo-sefting epoxy adhesive hardens and the tube body 28 is completely secured to the enclosure 27, assembly of the optical element module 22 is complete.

An optical connector housing 23 constituting the optical connector 21 is formed into a shape with its front surface and rear surface open respectively as illustrated. The opening on the front surface is formed as a connector fitting part 47 into which a counterpart optical connector is fitted. The opening on the rear surface is formed as a module receiving part 48 for receiving the optical element module 22. Between the connector fitting part 47 and the module receiving part 48 is formed a partition wall 49. A through hole 50 is formed in the partition wall 49. The through hole 50 is formed into a stepped shape so that the tube part 44 of the optical element module 22 will be inserted and the lid part 43 will be abutted on the stepped part when the optical element module 22 is received in the module receiving part 48.

The optical connector housing 23 is formed so that the tube part 44 will protrude into the connector fitting part 47 when the optical element module 22 is received in the module receiving part 48. When the tube part 44 protrudes into the connector fitting part 47, the ferrule of the counterpart optical connector is inserted into the tube part 44 and guided into position when optical connectors are fitted into each other.

A housing cap 24 includes a locking projection 52 engaged to a locking concave part 51 formed on the module receiving part 48 of the optical connector housing 23. The housing cap 24 includes a plurality of pressing parts 53 for pressing the optical element module 22 against the partition wall 49 of the optical connector housing 23 while locked to the module receiving part 48.

When the optical element module 22 is received in the module receiving part 48 and the housing cap 24 is locked to the module receiving part 48, assembly of the optical connector 21 is complete. The optical element module 22 is fixed without a backlash.

When assembly of the optical connector 21 is complete, the optical connector 21 is fixed to the surface of a substrate. The lead frame 26 of the optical element module 22 penetrates the through hole of the substrate and is soldered to the rear surface of the substrate. Part of the lead frame 26 may be bent and mounted on the substrate. A numeral 54 represents a substrate fixing part formed on the optical housing 23. The substrate fixing part 54 is inserted into the substrate and is fixed thereto.

Next, the coupling efficiency by the optical communication lens 45 will be described referring to Fig. 6. Fig. 6 is an explanatory drawing concerning the coupling efficiency. Explanation is made on the result of evaluation assuming that the diameter of the optical fiber is 200 µm.

Referring to Fig. 6, light (an optical signal) 55 from a light emitting element 25 is propagated through the optical communication lens 45 having an asymmetric shape including a first aspherical convex lens part 45a and a second aspherical convex lens part 45b. The diffused light 55 from the light emitting element 25 enters in the first aspherical convex lens part 45a and is propagated inside an intermediate part 45c in an extended fashion in the direction of propagation. The light 55 is emitted from the second aspherical convex lens part 45b and is condensed toward a focal point. The optical communication lens 45 with the desired aberration described above obtained with this shape provides a spot diameter of 42 micrometers at the focal point, a sufficient value with respect to an optical fiber having a diameter of 200 micrometers. According to this result, the spot diameter obtained is within some 120 micrometers even when the terminal of the optical fiber is brought near or placed away from the optical communication lens 45, or is dislocated by ±320 micrometers with respect to the focal point. The optical communication lens 45 thus offers good coupling efficiency.

As a comparison example of the optical communication lens 45, assume, while not shown, a lens of a symmetric shape using the first aspherical convex lens part 45a in each side (the optical communication lens 45 with the second aspherical convex lens part 45b replaced with the first aspherical convex lens part 45a). In the above evaluation method, a spot diameter of 230 micrometers at the focal point is obtained. This is not a spot diameter sufficient for the optical fiber having a diameter of 200 micrometers. The coupling efficiency in this example is about 90 percent. The spot diameter obtained is some 290 micrometers when the optical fiber terminal is brought near or placed away from the optical communication lens. A sufficient spot diameter is not obtained in this case either (the corresponding coupling efficiency is as low as about 60 percent).

As described referring to Figs. 1 through 6, the invention provides an advantage that optical coupling efficiency is enhanced by the optical communication lens 45 and the optical element module 22.

The invention may be modified in various ways without departing from the scope and spirit thereof.

## Claims

1. An optical communication lens arranged between an optical element and an optical fiber terminal, comprising:
a first lens part having an aspherical convex shape facing the optical element;
a second lens part having an aspherical convex shape facing the optical fiber terminal; and
an intermediate part integrally formed with the first lens part and the second lens part therebetween,
wherein the first lens part, the second lens part and the intermediate part are integrally formed and are comprised of a resin having optical transparency;
wherein shapes of the first lens part and the second lens part are asymmetric to each other; and
wherein the second lens part is thicker than the first lens part.

2. The optical communication lens according to claim 1,
wherein the optical element is a light emitting element; and
wherein the first lens part is formed into a shape that when a light from the light emitting element passes through from the first lens part to the second lens part, the light propagating through the intermediate part is extended in a direction of propagation.

3. The optical communication lens according to claim 1,
wherein the optical element is a light receiving element; and
wherein the second lens part is formed into a shape that when a light from the optical fiber terminal passes through from the second lens part to the first lens part, the light propagating through the intermediate part is narrowed in a direction of propagation.

4. The optical communication lens according to claim 1,
wherein the optical element is Vertical Cavity Surface Emitting Laser (VCSEL) or Photo Diode (PD); and
wherein the optical fiber is Polymer Clad Fiber (PCF).

5. A tube body for a optical device module having an optical element, comprising:
a cylindrical tube part for containing an optical fiber terminal or a ferrule mounted on the optical fiber terminal; and
an optical communication lens to be arranged between the optical element and the optical fiber terminal,
wherein the optical communication lens includes:
a first lens part having an aspherical convex shape facing the optical element;
a second lens part having an aspherical convex shape facing the optical fiber terminal; and
an intermediate part integrally formed with the first lens part and the second lens part therebetween,
wherein the optical communication lens is comprised of a resin having optical transparency;
wherein shapes of the first lens part and the second lens part are asymmetric to each other;
wherein the second lens part is thicker than the first lens part; and
wherein the optical communication lens is integrally formed with the cylindrical tube part therein.
